Europäisches Patentamt

European Patent Office

Office européen des brevets

(11) Veröffentlichungsnummer: **0 080 629 B1**

# EUROPÄISCHE PATENTSCHRIFT

(45) Veröffentlichungstag der Patentschrift:
27.03.85

(21) Anmeldenummer: 82110459.3

(22) Anmeldetag: 12.11.82

(51) Int. Cl.⁴: **H 01 B 1/16**, H 01 B 3/18, H 01 C 17/06, C 09 D 11/00

(54) **Paste zum Bedrucken von Substraten mittels eines elastisch verformbaren Stempels.**

(30) Priorität: 17.11.81 DE 3145583

(43) Veröffentlichungstag der Anmeldung:
08.06.83 Patentblatt 83/23

(45) Bekanntmachung des Hinweises auf die Patenterteilung:
27.03.85 Patentblatt 85/13

(84) Benannte Vertragsstaaten:
DE FR GB IT SE

(56) Entgegenhaltungen:
DE - A - 2 935 421
DE - A - 3 002 112
GB - A - 1 399 961
US - A - 3 962 143
US - A - 4 032 350
US - A - 4 051 074

(73) Patentinhaber: ROBERT BOSCH GMBH, Postfach 50, D-7000 Stuttgart 1 (DE)

(72) Erfinder: Grünwald, Werner,
Robert-Schuman-Strasse 21, D-7016 Gerlingen (DE)
Erfinder: Holfelder, Gerhard, Auf der Steige 13,
D-7251 Weissach (DE)
Erfinder: de la Prieta, Claudio, Schwarzwaldstrasse 81,
D-7000 Stuttgart 80 (DE)
Erfinder: Schmid, Kurt, Schlossstrasse 55,
D-7257 Ditzingen (DE)

**Beschreibung**

Die Erfindung geht aus von einer Paste nach der Gattung des Hauptanspruchs. Aus der DE-OS 3 002 112 ist bereits eine Paste mit vorgebbarer elektrischer Leitfähigkeit bekannt, die neben Äthylcellulose, α-Terpineol und Benzylalkohol als wesentlichen Bestandteil einen Polyester enthält und wo durch die geeignete Wahl von Zusatzstoffen das Ausmaß der elektrischen Leitfähigkeit eingestellt werden kann.

Diese Paste wie auch andere auf dem Markt erhältliche Pasten lassen sich sehr gut, beispielsweise auf Substraten aus Glas oder Keramik, mit Hilfe der Siebdrucktechnik verarbeiten. Jedoch wird die Anwendung der Siebdrucktechnik dann problematisch, wenn es darum geht, unebene Substrate, beispielsweise in Form von Rohren von 1 bis 2 cm Durchmesser, zu bedrucken. Für das Bedrucken derartiger Substrate mit Druckfarben ist es bekannt, den Auftrag dieser Farben mittels eines elastisch verformbaren Stempels vorzunehmen, wobei der Stempel die Farbe von einem Klischee in der vorgegebenen Menge und geometrischen Gestaltung abnimmt und auf das zu bedruckende Substrat überträgt. Bei dem Versuch, diese vom Farbdruck her bekannte Technik auf elektrisch wirksame Schichten zur Herstellung elektrischer Bauteile zu übertragen, stellte sich jedoch heraus, daß die hierfür bisher bekannten Pasten, die sich vor allem beim Siebdruck bewährt haben, für das hier vorgesehene Druckverfahren ungeeignet sind, da die Übertragbarkeit dieser Pasten von dem elastisch verformbaren Stempel, der beispielsweise aus Silikongummi besteht, auf die aus Keramik oder Glas bestehenden Substrate völlig ungenügend ist. Man war zunächst der Meinung, daß man die vorhandenen Pasten, die sich für den Siebdruck eignen, lediglich ein wenig verdünnen muß, um sie für den Druck mit dem elastisch verformbaren Stempel geeignet zu machen, es stellte sich aber heraus, daß ein solches einfaches Verdünnen nicht zu einer Lösung des Problems führte.

Die erfindungsgemäße Paste mit den kennzeichnenden Merkmalen des Hauptanspruchs hat demgegenüber den Vorteil, daß sich mit diesen Pasten eine hervorragende Übertragbarkeit von dem elastisch verformbaren Stempel auf das Substrat ergibt, so daß es mit Hilfe dieser Paste ohne Schwierigkeiten möglich wird, das Druckverfahren, wie es bereits vielfach für ebene elektrische Bauelemente benutzt wird, nun auch mit Hilfe der Übertragung von einem elastisch verformbaren Stempel auf unebene Substrate wie beispielsweise Lambda-Sonden anzuwenden. Besonders vorteilhaft ist es, daß diese Paste für verschiedene Feststoffarten, nämlich für Metallpulver, Keramikpulver oder Glaspulver sowie auch Mischungen aus diesen einsetzbar ist, so daß man, abhängig von dem eingesetzten Feststoff, sowohl leitfähige Schichten als auch Widerstandsschichten und isolierende Schichten mit dieser Paste übertragen kann. So lassen sich beispielsweise, wenn man als Feststoff Aluminiumoxid einsetzt, in hervorragender Weise isolierende Schichten auf ein Substrat aufdrucken.

Durch die in den Unteransprüchen aufgeführten Maßnahmen sind vorteilhafte Weiterbildungen und Verbesserungen der im Hauptanspruch angegebenen Paste möglich. Als besonders vorteilhaft hat sich eine Paste herausgestellt, bei welcher der organische Träger aus 6 Gew.-% Äthylcellulose, 79 Gew.-% α-Terpineol und 15 Gew.-% Benzylalkohol besteht. Falls eine noch weitergehende Verbesserung der Übertragbarkeit erforderlich ist, ist es besonders vorteilhaft, der Mischung noch einen Anteil von 1 bis 20 Gew.-% Polyäthylenglykol zuzumischen. In diesem Falle ist die Mischung jedoch möglichst rasch zu verarbeiten, da sie nicht so stabil ist wie eine Mischung, die kein Polyäthylenglykol enthält.

Im folgenden wird die Erfindung anhand einer elektrisch leitfähigen Paste, wie sie beispielsweise zur Herstellung von Anschlußleiterbahnen oder Elektroden auf keramischen Substraten Verwendung finden kann, näher erläutert. In diesem Falle wird als Feststoff ein Gemisch von Platin und Zirkondioxid eingesetzt, wobei das Volumenverhältnis Platin zu Zirkondioxid bei 60 : 40 liegt und ein Zirkondioxid eingesetzt wird, das mit Yttriumoxid vollstabilisiert ist. Wichtig ist, daß das Platin nicht in zu feiner Verteilung verwendet wird; es sollte eine Korngröße um 1 µm herum aufweisen. Auch das Zirkondioxid sollte eine bestimmte Korngröße aufweisen, wobei sich eine solche besonders bewährt hat, die sich bei einer spezifischen Oberfläche von 11 m²/g ergibt. Eine gut leitfähige Schicht aus Platin mit guten katalytischen Eigenschaften, wie sie für die Elektroden von Lambda-Sonden notwendig ist, bekommt man, wenn der Platinanteil, bezogen auf das Gesamtgewicht der Paste, bei 64% liegt.

Zur Herstellung der Paste werden zunächst 6 Gew.-% Äthylcellulose, 79 Gew.-% α-Terpineol und 15 Gew.-% Benzylalkohol in einem Dreiwalzenstuhl gründlich gemischt und anschließend der aus 60 Vol.-% des genannten Platins und 40 Vol.-% des vollstabilisierten Zirkondioxids gut gemischte Feststoff ebenfalls im Dreiwalzenstuhl zu dem zuvor hergestellten organischen Träger gegeben und gut durchmischt. Die dabei entstehende Paste läßt sich sehr gut verarbeiten und ist gut lagerfähig.

Es hat sich allgemein herausgestellt, daß die Verwendbarkeit einer solchen Paste für ein Druckverfahren mittels eines elastisch verformbaren Stempels ganz wesentlich zum einen von dem Gehalt an Feststoff und zum anderen von der Viskosität der Paste in Abhängigkeit von der gerade herrschenden mechanischen Beanspruchung abhängt. Die Äthylcellulose als Bestandteil des organischen Trägers hat im wesentlichen die Funktion eines Bindemittels, während die Komponenten α-Terpineol und Benzylalkohol in diesen Kombinationen dazu dienen, die Viskosität richtig einzustellen und, was wesentlich ist, als Thixotropiermittel dient.

In der gleichen Weise, wie dies soeben für elektrisch leitfähige Pasten beschrieben wurde, können

2

auch Widerstandspasten oder isolierende Pasten durch entsprechende Wahl des Feststoffes hergestellt werden. Dabei hat sich gezeigt, daß der organische Träger universell für alle diese Möglichkeiten in gleicher Weise einsetzbar ist und die gleichen vorteilhaften Ergebnisse bezüglich der Übertragbarkeit der Flächenmuster ergibt.

**Patentansprüche**

1. Aus einem Feststoff oder Feststoffgemisch und einem organischen, Äthylcellulose, $\alpha$-Terpineol und Benzylalkohol enthaltenden Träger bestehende Paste zum Auftrag von Mustern auf vorgegebene Bereiche eines vorzugsweise unebenen Substrates mittels eines elastisch verformbaren Stempels in einem Druckverfahren, dadurch gekennzeichnet, daß das Mischungsverhältnis von Feststoff oder Feststoffgemisch zu organischem Träger, bezogen auf die Gewichtsanteile, zwischen 6 : 4 und 8 : 2 liegt und der organische Träger besteht aus:

4—14 Gew.-% Äthylcellulose,
73—82 Gew.-% $\alpha$-Terpineol und
5—17 Gew.-% Benzylalkohol.

2. Paste nach Anspruch 1, dadurch gekennzeichnet, daß der organische Träger zusätzlich 1—20 Gew.-% Polyäthylenglykol enthält.
3. Paste nach Anspruch 1, dadurch gekennzeichnet, daß der organische Träger besteht aus:

6 Gew.-% Äthylcellulose,
79 Gew.-% $\alpha$-Terpineol und
15 Gew.-% Benzylalkohol.

4. Paste nach einem der Ansprüche 1 bis 3, dadurch gekennzeichnet, daß der Feststoff bzw. das Feststoffgemisch aus einem Metallpulver und/oder aus einem Keramikpulver und/oder aus einem Glaspulver besteht.
5. Paste nach Anspruch 4 zum Auftrag von elektrisch leitfähigen Mustern, dadurch gekennzeichnet, daß der Feststoff aus einem Gemisch von Platin und Zirkondioxid besteht.
6. Paste nach Anspruch 5, dadurch gekennzeichnet, daß das Volumenverhältnis von Platin zu Zirkondioxid zwischen 50 : 50 und 80 : 20 liegt.
7. Paste nach einem der Ansprüche 5 oder 6, dadurch gekennzeichnet, daß der Feststoff vollstabilisiertes Zirkondioxid enthält.
8. Paste nach einem der Ansprüche 5 bis 7, dadurch gekennzeichnet, daß das Platin eine Korngrößenverteilung von >70% zwischen 0,5 und 3 µm und das Zirkondioxid eine spezifische Oberfläche zwischen 8 und 14 m$^2$/g aufweisen.
9. Paste nach einem der Ansprüche 5 bis 8, dadurch gekennzeichnet, daß der Platinanteil, bezogen auf das Gesamtgewicht der Paste, zwischen 60 und 70% liegt.
10. Paste nach Anspruch 9, gekennzeichnet durch einen Platinanteil von 64%, bezogen auf das Gesamtgewicht der Paste.
11. Paste nach Anspruch 1, gekennzeichnet durch folgende Zusammensetzung:

1,5 Gew.-% Äthylcellulose,
19,7 Gew.-% $\alpha$-Terpineol,
3,75 Gew.-% Benzylalkohol,
64,0 Gew.-% Platin mit einer Korngröße im Bereich von 1 µm,
11,0 Gew.-% vollstabilisiertes Zirkondioxid mit einer spezifischen Oberfläche von 11 m$^2$/g.

12. Verwendung der Paste nach einem der Ansprüche 5 bis 11, zur Herstellung einer Innen- und/oder Außenelektrode einer Lambda-Sonde.

**Claims**

1. Paste which consists of a solid or solid mixture and of an organic carrier containing ethylcellulose, $\alpha$-terpineol and benzyl alcohol and which is intended for applying patterns to predetermined regions of a preferably uneven substrate by means of an elastically deformable stamp in a printing process, characterised in that the mixing ratio between the solid or solid mixture and the organic carrier in relation to the proportions by weight is between 6 : 4 and 8 : 2, and the organic carrier consists of:

4 to 14% by weight of ethylcellulose,
73 to 82% by weight of $\alpha$-terpineol, and
5 to 17% by weight of benzyl alcohol.

3

2. Paste according to Claim 1, characterised in that the organic carrier additionally contains 1 to 20% by weight of polyethylene glycol.

3. Paste according to Claim 1, characterised in that the organic carrier consists of:

    6% by weight of ethylcellulose,
    79% by weight of ⋅ᴧ-terpineol, and
    15% by weight of benzyl alcohol.

4. Paste according to one of Claims 1 to 3, characterised in that the solid or the solid mixture consists of a metal powder and/or of a ceramic powder and/or of a glass powder.

5. Paste according to Claim 4 for applying electrically conductive patterns, characterised in that the solid consists of a mixture of platinum and zirconium dioxide.

6. Paste according to Claim 5, characterised in that the ratio by volume of platinum to zirconium dioxide is between 50 : 50 and 80 : 20.

7. Paste according to one of Claims 5 or 6, characterised in that the solid contains fully stabilised zirconium dioxide.

8. Paste according to one of Claims 5 to 7, caracterised in that the platinum has a grain-size distribution of > 70% between 0.5 and 3 microns, and the zirconium dioxide has a specific surface area of between 8 and 14 $m^2/g$.

9. Paste according to one of Claims 5 to 8, caracterised in that the proportion of platinum in relation to the total weight of the paste is between 60 and 70%.

10. Paste according to Claim 9, characterised by a proportion of platinum of 64% in relation to the total weight of the paste.

11. Paste according to Claim 1, characterised by the following composition:

     1.5% by weight of ethylcellulose,
    19.7% by weight of $\alpha$-terpineol,
     3.75% by weight of benzyl alcohol,
    64.0% by weight of platinum with a grain size in the region of 1 micron,
    11.0% by weight of fully stabilised zirconium dioxide with a specific surface area of 11 $m^2/g$.

12. Use of the paste according to one of Claims 5 to 11 for the production of an inner and/or outer electrode of a lambda probe.

**Revendications**

1. Pâte constituée d'une matière solide, ou d'un mélange de matières solides et d'un support organique constitué d'éthylcellulose, d',ᴧ-terpinéol et d'alcool benzylique pour l'application de dessins sur une zone déterminée d'un substrat de préférence inégal ou non-plan, au moyen d'un tampon déformable élastiquement dans une opération d'impression, pâte caractérisée en ce que le rapport entre la matière solide ou le mélange de matières solides et le support organique, calculé sur les proportions en poids dans le mélange, se situe entre 6 : 4 et 8 : 2, et que le support organique est constitué de:

    4 à 14% en poids d'éthylcellulose,
    73 à 82% en poids d'$\alpha$-terpinéol,
    5 à 17% en poids d'alcool benzylique.

2. Pâte suivant la revendication 1, caractérisée en ce que le support organique contient en plus 1 à 20% en poids de polyéthylèneglycol.

3. Pâte suivant la revendication 1, caractérisée en ce que le support organique est constitué de:

    6% en poids d'éthylcellulose,
    79% en poids d',ᴧ-terpinéol,
    15% en poids d'alcool benzylique.

4. Pâte suivant l'une des revendications 1 à 3, caractérisée en ce que la matière solide, ou le mélange de matières solides est constitué par une poudre métallique, et/ou une poudre céramique, et/ou une poudre de verre.

5. Pâte suivant la revendication 4 pour l'application de dessins conducteurs de l'électricité, caracté risée en ce que la matière solide est constituée par un mélange de platine et de dioxyde de zirconium.

6. Pâte suivant la revendication 5, caractérisée en ce que le rapport en volume entre le platine et le dioxyde de zirconium se situe entre 50 : 50 et 80 : 20.

7. Pâte suivant l'une des revendications 5 et 6, caractérisée en ce que la matière solide contient du

**0 080 629**

dioxyde de zirconium complètement stabilisé.

8. Pâte suivant l'une des revendications 5 à 7, caractérisée en ce que le platine présente une granulométrie où plus de 70% se situent entre 0,5 et 3 microns, et que le dioxyde de zirconium présente une surface spécifique entre 8 et 14 m$^2$/g.

9. Pâte suivant l'une des revendications 3 à 8, caractérisée en ce que la proportion de platine, calculée sur le poids total de la pâte se situe entre 60 et 70%.

10. Pâte suivant la revendication 9, caractérisée en ce que la proportion de platine est de 64% calculé sur le poids total de la pâte.

11. Pâte suivant la revendication 1, caractérisée en ce qu'elle présente la composition suivante:

  1,5% en poids d'éthylcellulose,
19,7% en poids d'$\alpha$-terpinéol,
  3,5% en poids d'alcool benzylique,
64% en poids de platine ayant une grosseur de grain de l'ordre de 1 micron,
11% en poids de dioxyde de zirconium ayant une surface spécifique de 11 m$^2$/g.

12. Utilisation de la pâte suivant une des revendications 5 à 11, pour la fabrication d'une électrode intérieure et/ou extérieure d'une sonde Lambda.